# EUROPEAN PATENT SPECIFICATION

(11) **EP 2 806 455 B1**
(45) Date of publication and mention of the grant of the patent: **04.07.2018**
(21) Application number: 13175376.6
(22) Date of filing: 05.07.2013
(51) Int. Cl.: H01L 23/427, H01L 23/373, F28F 21/04

(54) **Heat dissipation plate**
Wärmeableitungsplatte
Plaque de dissipation de chaleur

(30) Priority: 21.05.2013 TW 102117918
(43) Date of publication of application: 26.11.2014
(73) Proprietor: Subtron Technology Co. Ltd., 303 Hukou Township, Hsinchu County (TW)
(72) Inventor: Chen, Ching-Sheng, 303 Hukou Township, Hsinchu County (TW)
(74) Representative: 2K Patentanwälte Blasberg Kewitz & Reichel

(56) References cited:
- EP-A2- 2 253 918
- EP-A2- 2 258 998
- JP-A- 2004 212 040
- JP-A- 2011 096 994
- US-A1- 2011 284 188
- US-B1- 7 051 793

## Description

### Field of the Invention

The invention relates to a heat dissipation plate, and more particularly to a heat dissipation plate that is suitable for carrying at least one heat generating element.

### Description of Related Art

According to a commonly used existing light emitting diode (LED) package structure, a LED chip needs to be packaged before use, and a large amount of heat will be generated while the LED chip emits light. If the heat generated by the LED chip cannot be dissipated and keeps accumulating within the LED package structure, the temperature of the LED package structure will continuously increase. Thus, due to the excessive heat, the LED chip may encounter an issue of luminance decay, and the service life of the LED chip may be shortened; what is more, permanent damages to the LED chip may be caused in some cases.

The conventional LED chips are mostly disposed on the heat dissipation plate which uses a metallic circuit to dissipate heat. However, the thermal expansion coefficient of the metallic circuit is much greater than the thermal expansion coefficient of the LED chips, i.e., these two thermal expansion coefficients are mismatched. In addition, the increasing thermal stress and warpage generated by the LED chips may lead to a reliability decrease in the LED chips and the heat dissipation plate. Therefore, how to increase the heat dissipation effect of the LED chips and improve the reliability of the LED chips and the heat dissipation plate now has become an important issue.

EP 2 253 918 A2 discloses a heat transfer device that includes a shell, wherein that shell is an enclosure that prevents matter from within the shell from being exchanged with matter from outside the shell. In particular a porous particle layer is present on the inner surface of the shell that encloses the formed vapor space. Therefore, a heat transfer device is disclosed that has a heat coefficient that is closely matched to semiconductor materials. However, the above mentioned heat transfer device is not equipped to rapidly exchange heat and there exists no way communicates with the fluid chamber C through the bottom part of the device to improve the overall heat dissipation efficiency of the heat.US 7 051 793 B1 discloses a cooler in the form of a heat pipe with a housing and an interior space to hold a liquid or heat-transport medium. The cooler has a first cooling area, a second cooling area and is formed by a plurality of plates that have a plurality of openings in order to form a vapor channel structure with at least one vapor channel. In particular the cooler is built as a heat pipe but in contrast to a conventional heat pipe contains very flat-shape with flat surfaces at the top and bottom. However, the design of this invention is also not directed to provide a rapid heat transfer, since flat surfaces (from the inside) are used.

JP 2011 096994 A discloses a cooler with a refrigerant charged in a plate-like container with (at least) partial areas of two opposite principal surfaces , wherein the container is made of dense ceramics and / or porous ceramic bodies. However, also the design of this invention does not provide a rapid heat transfer, since flat surfaces are used.

JP 2004 212040 A discloses a heat sink to improve the efficiency of a heat pipe that is composed such that several pillars that are spatially separated are provided between two first walls the define an internal space of a hollow body (i.e. a chamber) which is constituting the heat pipe, wherein the pillars are directly coupled with the walls and have a high thermal conductivity (e.g. metal), thus passing through the hollow body. Moreover, at least one capillary area that is formed by particles is formed. Therefore, the invention does indeed improve the heat transfer efficiency to a certain subtend. However, due to the pillars that are passing through the hollow body, the flow of the cooling liquid or vapor is affected negatively since the liquid must circumvent said pillars and the flow velocity is decreased which has a negative effect on heat transfer efficiency.

US 2011 / 284188 A1 discloses a system and a method to fabricate a heat spreader system that is including a bottom substrate comprising wicks and nano wicks that are recessing from the bottom substrate, a center substrate bonding to said bottom substrate and bonding to a top substrate, thus establishing a vapor chamber. The mentioned nano wicks may be microporous carbon nanotube wicks and are typically individually grown on a spreader in areas near the heat source. Though the invention might improve the heat transfer efficiency it comprises the very costly step of growing nanotube wicks. Moreover, no opening in the vapor chamber is included thus not allowing to exchange the coolant.

### SUMMARY OF THE INVENTION

The invention provides a heat dissipation plate which achieves a very effective heat dissipation with conventional materials such as metals at relatively low costs.

The heat dissipation plate of the invention includes a heat-conductive material layer, a first metal layer, a metal substrate, and a metal ring frame. The heat-conductive material layer has an upper surface and a lower surface opposite to each other, and a material of the heat-conductive material layer includes ceramic or silicon germanium. The first metal layer is disposed on the lower surface of the heat-conductive material layer and has a first rough surface with alternating concave-convex structures. The metal substrate is disposed below the first metal layer and has a second rough surface with alternating concave-convex structures. The metal ring frame is disposed between the first metal layer and the metal substrate, wherein a respective Rymax of the first and second rough surfaces with alternating concave-convex structures ranges from several micrometers to several centimeters. The first rough surface with alternating concave-convex structures, the metal ring frame, and the second rough surface with alternating concave-convex structures define a fluid chamber, and a working fluid flows in the fluid chamber.

In an embodiment of the invention, the heat-conductive material layer further includes at least one conductive through hole structure. The conductive through hole structure exposes a portion of the first metal layer and is electrically connected to the first metal layer.

In an embodiment of the invention, the heat dissipation plate further includes a second metal layer. The second metal layer is disposed on the upper surface of the heat-conductive material layer, and the second metal layer entirely covers or exposes a portion of the heat-conductive material layer.

In an embodiment of the invention, the heat dissipation plate further includes at least one opening. The opening penetrates through the heat-conductive material layer and the first metal layer and communicates with the fluid chamber. A thin metal pipe may be inserted into the opening for gas suction or fluid injection, such that the fluid chamber is in a low vacuum state; after that, the inserted thin metal pipe is closed.

In an embodiment of the invention, the heat dissipation plate further includes at least one opening. The opening penetrates through the metal ring frame and communicates with the fluid chamber.

In an embodiment of the invention, the heat dissipation plate further includes at least one opening. The opening penetrates through the metal substrate and communicates with the fluid chamber.

In an embodiment of the invention, a material of the first metal layer, a material of the metal substrate, and a material of the metal ring frame include copper, aluminum, or an alloy thereof.

In an embodiment of the invention, the working fluid includes air or liquid.

Based on the above, the material of the heat-conductive material layer of the heat dissipation plate of the invention is ceramic or silicon germanium having high thermal conductivity. The first rough surface with alternating concave-convex structures of the first metal layer, the metal ring frame, and the second rough surface with alternating concave-convex structures of the metal substrate define a low-vacuum-level fluid chamber. Accordingly, the heat dissipation plate of the invention can be considered as a vapor chamber, and when a heat generating element (such as a LED chip) is disposed on the heat dissipation plate, the heat generated by the heat generating element can be dissipated due to the two-phase flow characteristics of the vapor chamber. Thereby, the heat generated by the heat generating element can be removed effectively, and the efficiency and the lifetime of the heat generating element may be increased.

In order to make the aforementioned and other features and advantages of the invention more comprehensible, several embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1 is a schematic cross-sectional view illustrating a heat dissipation plate according to an embodiment of the invention.
FIG. 2 is a schematic cross-sectional view illustrating a heat dissipation plate according to another embodiment of the invention.
FIG. 3 is a schematic cross-sectional view illustrating a heat dissipation plate according to another embodiment of the invention.
FIG. 4 is a schematic cross-sectional view illustrating a heat dissipation plate according to another embodiment of the invention.
FIG. 5 is a schematic cross-sectional view illustrating a heat dissipation plate according to another embodiment of the invention.
FIG. 6 is a schematic cross-sectional view illustrating a heat dissipation plate which holds a heat generating element according to an embodiment of the invention.
FIG 7 is a schematic cross-sectional view illustrating a heat dissipation plate which holds a heat generating element according to another embodiment of the invention.
FIG. 8 is a schematic cross-sectional view illustrating a heat dissipation plate which holds a heat generating element according to another embodiment of the invention.
FIG. 9 is a schematic cross-sectional view illustrating a heat dissipation plate which holds a heat generating element according to another embodiment of the invention.
FIG. 10 is a schematic cross-sectional view illustrating a heat dissipation plate which holds a heat generating element according to another embodiment of the invention.

### DESCRIPTION OF EMBODIMENTS

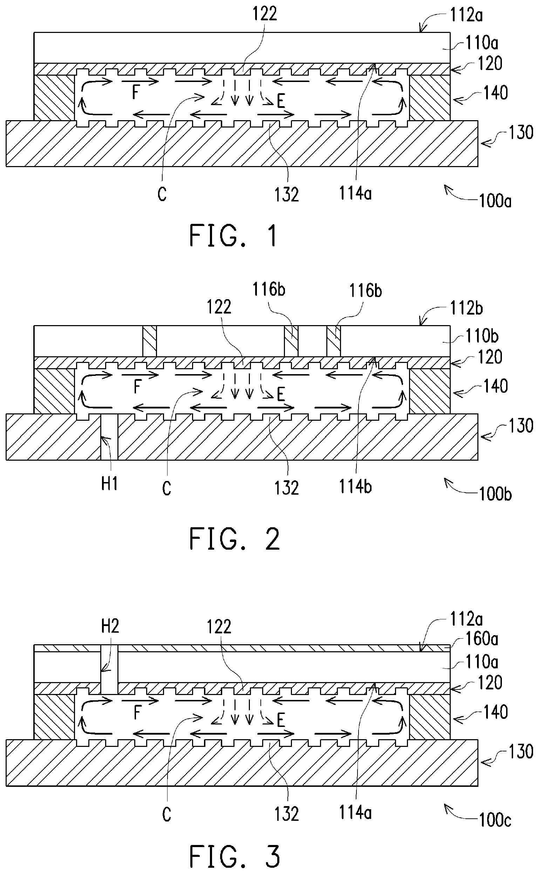

FIG. 1 is a schematic cross-sectional view illustrating a heat dissipation plate.

In FIG. 1, a heat dissipation plate 100a in the illustrative embodiment includes a heat-conductive material layer 110a, a first metal layer 120, a metal substrate 130, and a metal ring frame 140. In detail, the heat-conductive material layer 110a has an upper surface 112a and a lower surface 114a opposite to each other; in particular, a material of the heat-conductive material layer 110a includes ceramic or silicon germanium. The first metal layer 120 is disposed on the lower surface 114a of the heat-conductive material layer 110a and has a first rough surface with alternating concave-convex structures 122. The metal substrate 130 is disposed below the first metal layer 120 and has a second rough surface with alternating concave-convex structures 132. The metal ring frame 140 is disposed between the first metal layer 120 and the metal substrate 130. The first rough surface with alternating concave-convex structures 122, the metal ring frame 140, and the second rough surface with alternating concave-convex structures 132 define a fluid chamber C, and a working fluid F flows in the fluid chamber C.

More specifically, the first metal layer 120 described in the present embodiment is in direct contact with the lower surface 114a of the heat-conductive material layer 110a. In the present embodiment, a material of the first metal layer 120, a material of the metal substrate 130, and a material of the metal ring frame 140 include copper, aluminum, or an alloy thereof, wherein the materials of the first metal layer 120, the metal substrate 130, and the metal ring frame 140 can be the same or different, and the invention does not pose any limitation thereto. In addition, the fluid chamber C, for example, is a low-vacuum-level chamber, and the working fluid F, for example, is air or liquid.

In particular, the first rough surface with alternating concave-convex structures 122 of the first metal layer 120 described in the present embodiment, for example, is a continuous alternating concave-convex surface structure or a non-continuous alternating concave-convex surface structure, and the Rymax of the first rough surface with alternating concave-convex structures 122 ranges from several micrometers to several centimeters. The first rough surface with alternating concave-convex structures 122 may be considered as a capillary structure. On the other hand, the second rough surface with alternating concave-convex structures 132 of the metal substrate 130 described in the present embodiment, for example, is a continuous alternating concave-convex surface structure or a non-continuous alternating concave-convex surface structure, and the Rymax of the second rough surface with alternating concave-convex structures 132 ranges from several micrometers to several centimeters. The second rough surface with alternating concave-convex structures 132 may also be considered as a capillary structure. Here, the first rough surface with alternating concave-convex structures 122 and the second rough surface with alternating concave-convex structures 132, for example, are formed by mechanical processing (e.g., computer numerical control (CNC) milling, stamping, or sandblasting), chemical processing (e.g., electrochemical plating or etching), or physical grinding, which should not be construed as limitations to the invention.

The material of the heat-conductive material layer 110a of the heat dissipation plate 100a described in the present embodiment is ceramic or silicon germanium having high thermal conductivity, and the first rough surface with alternating concave-convex structures 122 of the first metal layer 120, the metal ring frame 140, and the second rough surface with alternating concave-convex structures 132 of the metal substrate 130 define a low-vacuum-level fluid chamber C. Accordingly, as a heat generating element (not shown) is disposed on the heat-conductive material layer 110a, the working fluid F inside the fluid chamber C absorbs heat E generated by the heat generating element and vaporizes on a low vacuum condition. At this time, the working fluid F absorbs the heat E and rapidly expands its volume, and the gas-phase working fluid F soon fills the whole fluid chamber C. When the gas-phase working fluid F is in contact with areas with low temperature, the gas-phase working fluid F is condensed, so as to allow the heat absorbed during vaporization to be released. After condensation, the liquid-phase working fluid F returns to the evaporating region (i.e., below the heat generating element) via a capillary action of the first rough surface with alternating concave-convex structures 122 and the second rough surface with alternating concave-convex structures 132. Therefore, via the repeated cycles of conduction, evaporation, convection, and condensation, the heat E generated by the heat generating element can be rapidly transferred to each portion of the heat dissipation plate 100a. In short, the heat dissipation plate 100a described in the present embodiment can be considered a vapor chamber having a flat structure and the satisfactory two-phase flow characteristics. Thereby, an excellent two-dimensional lateral thermal conduction effect may be provided, the heat generated by the heat generating element may be rapidly diffused to avoid a formation of hot spots in local regions, and the lifetime of the heat generating element may be extended.

On the other hand, the heat-conducting material layer 110a achieves thermal conduction effects, and the thermal expansion coefficient of the heat-conducting material layer 110a is relatively close to the thermal expansion coefficient of the heat generating element (not shown). Therefore, as the heat generating element is disposed on the heat-conductive material layer 110a, the difference of thermal expansion coefficients between the heat dissipation plate 100a and the heat generating element held by the heat dissipation plate 100a may be reduced, the corresponding stress increase between the heat generating element and the heat-conductive material layer 110a due to the significant difference between the two thermal expansion coefficients can be avoided, the heat generating element may be prevented from falling off or being damaged, and the reliability of the heat dissipation plate 100a may be enhanced.

Several embodiments are provided hereinafter to illustrate the structural designs of the heat dissipation plates 100b, 100c, 100d, and 100e. It should be mentioned that the reference numerals and some of the contents in the previous embodiment are used in the following embodiments, in which identical reference numerals indicate identical or similar components, and repeated description of the same technical contents is omitted. For a detailed description of the omitted parts, reference can be found in the previous embodiment, and no repeated description is contained in the following embodiments.

FIG. 2 is a schematic cross-sectional view illustrating a heat dissipation plate according to an embodiment of the invention. In FIG. 2, the heat dissipation plate 100b in the present embodiment is similar to the heat dissipation plate 100a in FIG. 1, and one of main differences is that the heat-conductive material layer 110b in the present embodiment has at least one conductive through hole structure 116b (FIG. 2 schematically illustrates three hole structures), and the conductive through hole structure 116b is connected to the upper surface 112b and the lower surface 114b and exposes a portion of the first metal layer 120. The conductive through hole structure 116b is electrically connected to the exposed portion of the first metal layer 120. In addition, the heat dissipation plate 100b further includes at least one opening HI, wherein the opening H1 penetrates through the metal substrate 130 and communicates with the fluid chamber C to improve the overall heat dissipation efficiency of the heat dissipation plate 100b by sucking gas from or injecting fluid into the fluid chamber C through the opening H1. A thin metal pipe (not shown) may be inserted into the opening H1 for gas suction or fluid injection, such that the fluid chamber C is in a low vacuum state; after that, the inserted thin metal pipe is closed.

FIG. 3 is a schematic cross-sectional view illustrating a heat dissipation plate according to another embodiment of the invention. In FIG. 3, the heat dissipation plate 100c in the present embodiment is similar to the heat dissipation plate 100a in FIG. 1, and one of main differences is that the heat dissipation plate 100c in the present embodiment further includes a second metal layer 160a. The second metal layer 160a is disposed on the upper surface 112a of the heat-conductive material layer 110a, and the second metal layer 160a entirely covers the heat-conductive material layer 110a.

In addition, the heat dissipation plate 100c further includes at least one opening H2. The opening H2 sequentially penetrates through the second metal layer 160a, the heat-conductive material 110a, and the first metal layer 120 and communicates with the fluid chamber C to improve the overall heat dissipation efficiency of the heat dissipation plate 100c by sucking gas from or injecting fluid into the fluid chamber C through the opening H2.

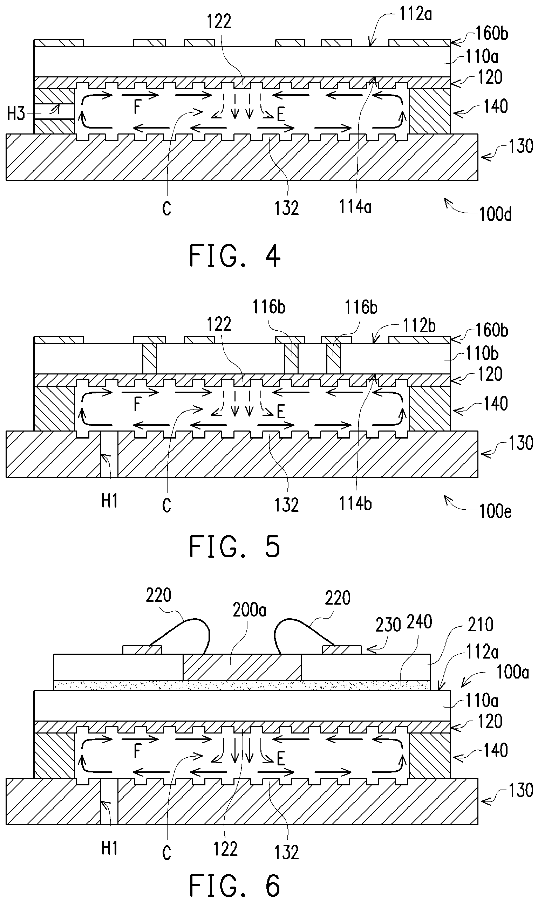

FIG. 4 is a schematic cross-sectional view illustrating a heat dissipation plate according to another embodiment of the invention. In FIG. 4, the heat dissipation plate 100d in the present embodiment is similar to the heat dissipation plate 100a in FIG. 1, and one of main differences is that the heat dissipation plate 100d in the present embodiment further includes a second metal layer 160b. The second metal layer 160b is disposed on the upper surface 112a of the heat-conductive material layer 110a, and the second metal layer 160b covers the heat-conductive material layer 110a and exposes a portion of the upper surface 112a of the heat-conductive material layer 110a. In addition, the heat dissipation plate 100d further includes at least one opening H3, and the opening H3 penetrates through the metal ring frame 140 and communicates with the fluid chamber C to improve the overall heat dissipation efficiency of the heat dissipation plate 100d by sucking gas from or injecting fluid into the fluid chamber C through the opening H3.

FIG. 5 is a schematic cross-sectional view illustrating a heat dissipation plate according to another embodiment of the invention. In FIG. 5, the heat dissipation plate 100e in the present embodiment is similar to the heat dissipation plate 100b in FIG. 2, and one of main differences is that the heat dissipation plate 100e in the present embodiment further includes a second metal layer 160b. The second metal layer 160b is disposed on the upper surface 112b of the heat-conductive material layer 110b, and the second metal layer 160b covers the heat-conductive material layer 110b and exposes a portion of the upper surface 112b of the heat-conductive material layer 110b.

Furthermore, the conductive through hole structure 116b, the second metal layers 160a and 160b, and the openings HI, H2, and H3 are also applicable in other embodiments not shown herein. According to the above descriptions in the previous embodiments, people having the ordinary skill in the art can use the aforementioned components to achieve the desired technical effects based on the actual requirements.

FIG. 6 is a schematic cross-sectional view illustrating a heat dissipation plate which holds a heat generating element according to an illustrative embodiment.

In FIG. 6, the heat dissipation plate 100a is suitable for carrying a LED chip 200a (i.e., the heat generating element), and the LED chip 200a is embedded in a dielectric layer 210 and electrically connected to circuits 230 on the dielectric layer 210 through a plurality of bonding wires 220. Moreover, the LED chip 200a and the dielectric layer 210 are fixed onto the upper surface 112a of the heat-conductive material layer 110a by an adhesive layer 240. Here, the adhesive layer 240, for example, can be a conductive adhesive layer or a non-conductive adhesive layer, and the invention does not pose any limitation thereto.

The heat-conductive material layer 110a in present embodiment achieves the heat dissipation effects, and the thermal expansion coefficient of the heat-conductive material layer 110a is close to the thermal expansion coefficient of the LED chip 200a (not shown). Therefore, as the LED chip 200a is disposed on the heat-conductive material layer 110a by the adhesive layer 240, the difference of thermal expansion coefficients between the heat dissipation plate 100a and the LED chip 200a held by the heat dissipation plate 100a may be effectively reduced, the corresponding stress increase between the heat generating element and the heat-conductive material layer 110a due to the significant difference between the two thermal expansion coefficients can be avoided, the LED chip 200a may be prevented from falling off or being damaged, and the reliability of the heat dissipation plate 100a may be enhanced. Furthermore, if the heat dissipation plate 100a only has the function of heat dissipation, the heat generated by the LED chip 200a may be rapidly transmitted to the external surroundings through the cycles of conduction, evaporation, convection, and condensation.

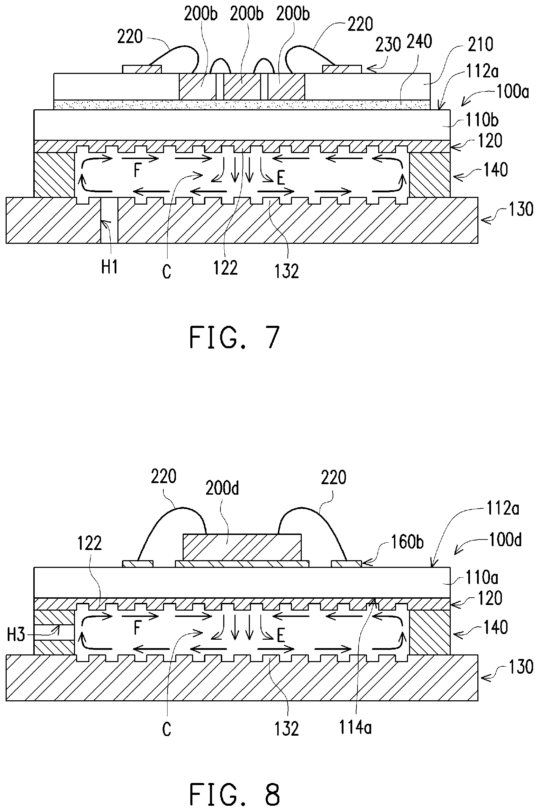

It is worth to mention that the invention does not limit the number of the LED chips 200a, although only one LED chip 200a is exemplified herein. However, with reference to FIG. 7, in another embodiment, the heat generating element can also be composed of a plurality of LED chips 200b connected in series or in parallel. This still belongs to a technical means adoptable in the invention and falls within the protection scope of the invention.

FIG. 8 is a schematic cross-sectional view illustrating a heat dissipation plate which holds a heat generating element according to another embodiment of the invention. In FIG. 8, the heat dissipation plate 100d is suitable for carrying a LED chip 200d (i.e., the heat generating element), wherein the LED chip 200d is disposed on the second metal layer 160b, and the LED chip 200d is structurally and electrically connected to the second metal layer 160b through a plurality of bonding wires 220. Here, the heat dissipation plate 100d not only has the function of heat dissipation but also has the function of electrical conduction.

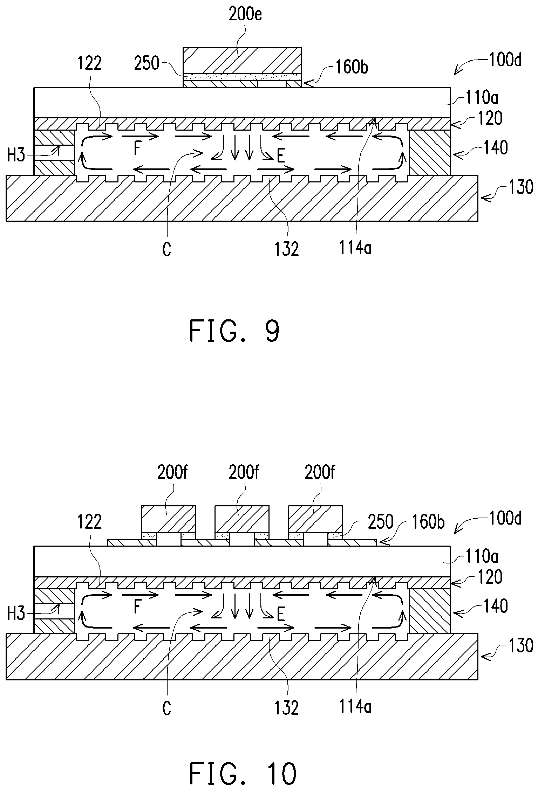

FIG. 9 is a schematic cross-sectional view illustrating a heat dissipation plate which holds a heat generating element according to another embodiment of the invention. In FIG. 9, the heat dissipation plate 100d is suitable for carrying a LED chip 200e (i.e., the heat generating element), wherein the LED chip 200e is disposed on the second metal layer 160b through the silver paste 250; that is, the LED chip 200e is electrically connected to the second metal layer 160b of the heat dissipation plate 100d by flip chip bonding. Here, the heat dissipation plate 100d not only has the function of heat dissipation but also has the function of electrical conduction.

It is worth to mention that the invention does not limit the number of the LED chips 200e, although only one LED chip 200e is exemplified herein. However, with reference to FIG. 10, in another embodiment, the heat generating element can also be composed of a plurality of LED chips 200f. This still belongs to a technical means adoptable in the invention and falls within the protection scope of the invention. Furthermore, the heat dissipation plate 100b, 100c, and 100d as mentioned above are applicable in other embodiments not shown herein. According to the above descriptions in the previous embodiments, people having the ordinary skill in the art can use the aforementioned components to achieve the desired technical effects based on the actual requirements.

In summary, the material of the heat-conductive material layer of the heat dissipation plate described in the invention is ceramic or silicon germanium having high thermal conductivity. The first rough surface with alternating concave-convex structures of the first metal layer, the metal ring frame, and the second rough surface with alternating concave-convex structures of the metal substrate define a low-vacuum-level fluid chamber. Therefore, the heat dissipation plate described in the invention can be considered as a vapor chamber, and when the heat generating element (e.g., a LED chip) is disposed on the heat dissipation plate, the heat generated by the heat generating element can be dissipated due to the two-phase flow characteristics of the vapor chamber. Thereby, the heat generated by the heat generating element can be removed efficiently, and the efficiency and the lifetime of the heat generating element can be increased.

## Claims

1. A heat dissipation plate (100a, 100b, 100c, 100d, 100e) comprising:
a heat-conductive material layer (110a, 110b) having an upper surface (112a, 112b) and a lower surface (114a, 114b) opposite to each other, wherein a material of the heat-conductive material layer (110a, 110b) comprises ceramic or silicon germanium;
a first metal layer (120) disposed on the lower surface (114a, 114b) of the heat-conductive material layer (110a, 110b)
a metal substrate (130) disposed below the first metal layer (120) ; and
a metal ring frame (140) disposed between the first metal layer (120) and the metal substrate (130), wherein
the first metal layer (120) has a first rough surface with alternating concave-convex structures (122);
the metal substrate (130) has a second rough surface with alternating concave-convex structures (132) ;
a respective Rymax of the first and second rough surfaces with alternating concave-convex structures (122, 132) ranges from several micrometers to several centimeters; and
wherein the first rough surface with alternating concave-convex structures (122) , the metal ring frame (140), and the second rough surface with alternating concave-convex structures (132) define a fluid chamber (C), and a working fluid ( F) flows in the fluid chamber (C) ;
**characterized in that**
the heat-conductive material layer (110b) further comprises at least one conductive through hole structure (116b), and the at least one conductive through hole structure (116b) exposes a portion of the first metal layer (120) and is electrically connected to the first metal layer (120) ; and/or
a second metal layer (160b) is disposed on the upper surface (112b) of the heat-conductive material layer (110b), wherein the second metal layer (160b) entirely covers or exposes a portion of the heat-conductive material layer (110b).

2. The heat dissipation plate (100c, 100d) as claimed in claim 1, further comprising:
a second metal layer (160a, 160b) disposed on the upper surface (112a) of the heat-conductive material layer (110a), wherein the second metal layer (160a, 160b ) entirely covers or exposes a portion of the heat-conductive material layer (110a).

3. The heat dissipation plate (100c) as claimed in any of the preceding claims, further comprising:
at least one opening (H2) penetrating through the heat-conductive material layer (110a) and the first metal layer (120) and communicating with the fluid chamber (C) .

4. The heat dissipation plate (100d) as claimed in any of the preceding claims, further comprising:
at least one opening (H3) penetrating through the metal ring frame (140) and communicating with the fluid chamber (C).

5. The heat dissipation plate (100b) as claimed in any of the preceding claims, further comprising:
at least one opening (H1) penetrating through the metal substrate (130) and communicating with the fluid chamber (C).

6. The heat dissipation plate (100a, 100b, 100c, 100d, 100e) as claimed in any of the preceding claims, wherein a material of the first metal layer (120), a material of the metal substrate (130), and a material of the metal ring frame (140) comprise copper, aluminum, or an alloy thereof.

7. The heat dissipation plate (100a, 100b, 100c, 100d, 100e) as claimed in any of the preceding claims, wherein the working fluid (F) comprises air or liquid.

## Patentansprüche

1. Wärmeableitplatte (100a, 100b, 100c, 100d, 100e), umfassend:
eine wärmeleitende Materialschicht (110a, 110b) mit einer Oberseite (112a, 112b) und einer Unterseite (114a, 114b), die einander gegenüberliegen, wobei ein Material der wärmeleitenden Materialschicht (110a, 110b) Keramik oder Siliziumgermanium umfasst;
eine erste Metallschicht (120), die auf der Unterseite (114a, 114b) der wärmeleitenden Materialschicht (110a, 110b) angeordnet ist,
ein Metallsubstrat (130), das unterhalb der ersten Metallschicht (120) angeordnet ist; und
einen Metallringrahmen (140), der zwischen der ersten Metallschicht (120) und dem Metallsubstrat (130) angeordnet ist, wobei
die erste Metallschicht (120) eine erste raue Oberfläche mit abwechselnd konkav-konvexen Strukturen (122) aufweist;
das Metallsubstrat (130) eine zweite raue Oberfläche mit abwechselnd konkav-konvexen Strukturen (132) aufweist;
ein jeweiliger Rymax der ersten und zweiten rauen Oberfläche mit abwechselnd konkav-konvexen Strukturen (122, 132) von mehreren Mikrometern bis zu mehreren Zentimetern reicht; und
wobei die erste raue Oberfläche mit abwechselnd konkav-konvexen Strukturen (122), der Metallringrahmen (140) und die zweite raue Oberfläche mit abwechselnd konkav-konvexen Strukturen (132) eine Fluidkammer (C) festlegen und ein Arbeitsfluid (F) in der Fluidkammer (C) strömt;
**dadurch gekennzeichnet, dass**
die wärmeleitende Materialschicht (110b) ferner mindestens eine leitende Durchgangslochstruktur (116b) aufweist und die mindestens eine leitende Durchgangslochstruktur (116b) einen Teil der ersten Metallschicht (120) freilegt und mit der ersten Metallschicht (120) elektrisch verbunden ist; und/oder
eine zweite Metallschicht (160b) auf der Oberseite (112b) der wärmeleitenden Materialschicht (110b) angeordnet ist, wobei die zweite Metallschicht (160b) einen Teil der wärmeleitenden Materialschicht (110b) vollständig bedeckt oder freilegt.

2. Wärmeableitplatte (100c, 100d) nach Anspruch 1, weiterhin umfassend:
eine zweite Metallschicht (160a, 160b), die auf der Oberseite (112a) der wärmeleitenden Materialschicht (110a) angeordnet ist, wobei die zweite Metallschicht (160a, 160b) einen Teil der wärmeleitenden Materialschicht (110a) vollständig bedeckt oder freilegt.

3. Wärmeableitplatte (100c) nach einem der vorhergehenden Ansprüche, weiterhin umfassend:
mindestens eine Öffnung (H2), die die wärmeleitende Materialschicht (110a) und die erste Metallschicht (120) durchdringt und mit der Fluidkammer (C) in Verbindung steht.

4. Wärmeableitplatte (100d) nach einem der vorhergehenden Ansprüche, weiterhin umfassend:
mindestens eine Öffnung (H3), die den Metallringrahmen (140) durchdringt und mit der Fluidkammer (C) in Verbindung steht.

5. Wärmeableitplatte (100b nach einem der vorhergehenden Ansprüche, weiterhin umfassend:
mindestens eine Öffnung (H1), die das Metallsubstrat (130) durchdringt und mit der Fluidkammer (C) in Verbindung steht.

6. Wärmeableitplatte (100a, 100b, 100c, 100d, 100e) nach einem der vorhergehenden Ansprüche, wobei ein Material der ersten Metallschicht (120), ein Material des Metallsubstrats (130) und ein Material des Metallringrahmens (140) Kupfer, Aluminium oder eine Legierung davon umfassen.

7. Wärmeableitplatte (100a, 100b, 100c, 100d, 100e) nach einem der vorhergehenden Ansprüche, wobei das Arbeitsfluid (F) Luft oder eine Flüssigkeit umfasst.

## Revendications

1. Une plaque de dissipation de chaleur (100a, 100b, 100c, 100d, 100e) comprenant:
une couche de matériau thermoconducteur (110a, 110b) ayant une surface supérieure (112a, 112b) et une surface inférieure (114a, 114b) opposées l'une à l'autre, dans laquelle un matériau de la couche de matériau thermoconducteur (110a, 110b) comprend de la céramique ou du silicium germanium;
une première couche métallique (120) disposée sur la surface inférieure (114a, 114b) de la couche de matériau thermoconducteur (110a, 110b)
un substrat métallique (130) disposé au-dessous de la première couche métallique (120) ; et
un cadre annulaire métallique (140) disposé entre la première couche métallique (120) et le substrat métallique (130), dans lequel
la première métallique (120) présente une première surface rugueuse avec des structures concaves-convexes en alternance (122) ;
le substrat métallique (130) présent une seconde surface rugueuse avec des structures concave-convexe en alternance (132) ;
un Rymax respectif des première et seconde surface rugueuse avec des structures concave-convexes en alternance (122, 132) s'étendent de quelques micromètres à plusieurs centimètres ; et
dans lequel la première surface rugueuse ayant des structures concave-convexe en alternance (122), le cadre annulaire métallique (140), et la seconde surface rugueuse avec des structures concave-convexe en alternance (132) définissent une chambre à fluide (C), et un fluide de travail (F) s'écoulant dans la chambre à fluide (C) ;
**caractérisé en ce que**
la couche de matériau thermoconducteur (110b) comporte en outre au moins une structure de trou traversant conducteur (116b), et la ou les structure(s) de trou traversant conducteur (116b) expose(nt) une partie de la première couche métallique (120) et est/sont électriquement connectée(s) à la première couche métallique (120) ; et/ou
une seconde couche métallique (160b) est disposée sur la surface supérieure (112b) de la couche de matériau thermoconducteur (110b), dans laquelle la seconde couche métallique (160b) recouvre entièrement ou expose une partie de la couche de matériau thermoconducteur (110b).

2. La plaque de dissipation de chaleur (100c, 100d) tel que revendiquée dans la revendication 1, comprenant en outre :
une seconde couche métallique (160a, 160b) disposée sur la surface supérieure (112a) de la couche de matériau thermoconducteur (110a), dans laquelle la seconde couche métallique (160a, 160b) recouvre entièrement ou expose une partie de la couche de matériau thermoconducteur (110a).

3. La plaque de dissipation de chaleur (100c) telle que revendiquée dans l'une quelconque des revendications précédentes, comprenant en outre:
au moins une ouverture (H2) pénétrant à travers la couche de matériau thermoconducteur (110a) et la première couche métallique (120) et communiquant avec la chambre à fluide (C).

4. La plaque de dissipation de chaleur (100d) telle que revendiquée dans l'une quelconque des revendications précédentes, comprenant en outre:
au moins une ouverture (H3) pénétrant à travers le cadre annulaire métallique (140) et communiquant avec la chambre à fluide (C).

5. La plaque de dissipation de chaleur (100b) telle que revendiqué dans l'une quelconque des revendications précédentes, comprenant en outre:
au moins une ouverture (H1) pénétrant à travers le substrat métallique (130) et communiquant avec la chambre à fluide (C).

6. La plaque de dissipation de chaleur (100a, 100b, 100c, 100d, 100e) telle que revendiquée dans l'une quelconque des revendications précédentes, dans laquelle un matériau de la première couche métallique (120), un matériau du substrat métallique (130) et un matériau du cadre annulaire métallique (140) comprend du cuivre, de l'aluminium ou un alliage de ces derniers.

7. La plaque de dissipation de chaleur (100a, 100b, 100c, 100d, 100e) telle que revendiquée dans l'une quelconque des revendications précédentes, dans laquelle le fluide de travail (F) comprend de l'air ou un liquide.
